# EUROPEAN PATENT APPLICATION

(11) **EP 4 228 054 A1**
(43) Date of publication of application: **16.08.2023**
(21) Application number: 21877726.6
(22) Date of filing: 07.10.2021
(51) Int. Cl.: H01M 10/46, H01R 13/46, H01M 50/202, H01M 50/244, H01M 50/284, H01M 50/584

(54) **HOLDING DEVICE**

(30) Priority: 07.10.2020 JP 2020169849; 07.10.2020 JP 2020169863
(71) Applicant: HONDA MOTOR CO., LTD., Minato-ku Tokyo 107-8556 (JP)
(72) Inventor: MATSUMOTO, Takashi, Wako-shi, Saitama 351-0193 (JP); YAMAMOTO, Kazuhiro, Wako-shi, Saitama 351-0193 (JP); TAKAHASHI, Tsutomu, Wako-shi, Saitama 351-0193 (JP); NIKAWA, Hidefumi, Wako-shi, Saitama 351-0193 (JP); IKUI, Kuniaki, Wako-shi, Saitama 351-0193 (JP)
(74) Representative: Feller, Frank
(86) International application number: PCT/JP2021/037230
(87) International publication number: WO 2022/075427

(57) **Abstract**

Provided is a battery exchanger (10) that holds a mobile battery (12), and comprises a male connector (64e) that is connected to a female connector (50) of the mobile battery (12) held in a slot sleeve (23) for holding the mobile battery (12), and a connector unit (64) that moves the male connector (64e) in a direction toward the female connector (50). The slot sleeve (23) includes a bottom cover (42) having a bottom part (23a), and the male connector (64e) and the connector unit (64) are attached to the bottom cover (42), and supported by the bottom cover (42).

## Description

### TECHNICAL FIELD

The present invention relates to a holding apparatus (holding device) that holds electric devices.

### BACKGROUND ART

JP 2018-163757 A discloses a holding apparatus that holds a storage battery.

### SUMMARY OF THE INVENTION

However, there is room for improvement with regard to the structure of the holding apparatus that holds an electric device such as a storage battery.

The present invention has an object of providing a better holding apparatus.

An aspect of the present invention is a holding apparatus that holds an electric device including a first electric terminal, the holding apparatus including: a holding portion configured to hold the electric device; a second electric terminal configured to be connected to the first electric terminal of the electric device held by the holding portion; and a drive portion configured to move the second electric terminal in a direction toward the first electric terminal and/or move the second electric terminal in a direction away from the first electric terminal, wherein: the holding portion is formed with a shape of a bottomed tube including a bottom portion and a tubular portion; the holding portion includes a first member that includes the bottom portion and a second member that is attached to the first member and that includes the tubular portion which surrounds an outer periphery of the electric device held in the holding portion; and the second electric terminal and the drive portion are attached to the first member and are supported by the first member.

According to the present invention, it is possible to provide a better holding apparatus.

### BRIEF DESCRIPTION OF DRAWINGS

FIG. 1 is an external schematic view of a battery exchanger;
FIG. 2 is a cross-sectional view of the battery exchanger;
FIG. 3 is a right side view of a slot;
FIG. 4 is a front view of the slot;
FIG. 5 is a cross-sectional view of the slot;
FIG. 6 is a perspective view of a mobile battery;
FIG. 7 is a top view of the mobile battery;
FIG. 8 is a bottom view of the mobile battery;
FIG. 9 is a cross-sectional view of the mobile battery;
FIG. 10 is a cross-sectional view of the slot;
FIG. 11 is a cross-sectional view of the slot;
FIG. 12 is a cross-sectional view of the slot;
FIG. 13 is a cross-sectional view of the slot;
FIG. 14 is a perspective view of a door;
FIG. 15 is a cross-sectional view of the slot;
FIG. 16A is a cross-sectional view of the slot;
FIG. 16B is a cross-sectional view of the slot;
FIG. 17 is a perspective view of the slot;
FIG. 18 is a perspective view of the slot;
FIG. 19 is a perspective view of the slot;
FIG. 20A is a cross-sectional view of a bottom cover assembly and the mobile battery;
FIG. 20B is a cross-sectional view of the bottom cover assembly and the mobile battery;
FIG. 20C is a cross-sectional view of the bottom cover assembly and the mobile battery;
FIG. 21 is a perspective view of a bottom cover;
FIG. 22 is a cross-sectional view of the slot;
FIG. 23 is a cross-sectional view of the slot;
FIG. 24 is a cross-sectional view of a holding detection switch and its surrounding region;
FIG. 25 is a schematic view of the holding detection switch;
FIG. 26 is a planar view of the holding detection switch and its surrounding region;
FIG. 27 is a perspective view of an electronic circuit board and its surrounding region;
FIG. 28 is a planar view of a connector unit;
FIG. 29A is a schematic view of a connection detection switch and a switch operating element;
FIG. 29B is a schematic view of the connection detection switch and the switch operating element;
FIG. 30A is a schematic view of the connection detection switch and a switch operating element;
FIG. 30B is a schematic view of the connection detection switch and the switch operating element; and
FIG. 31 is a perspective view of the slot.

### DETAILED DESCRIPTION OF THE INVENTION

### [First Embodiment]

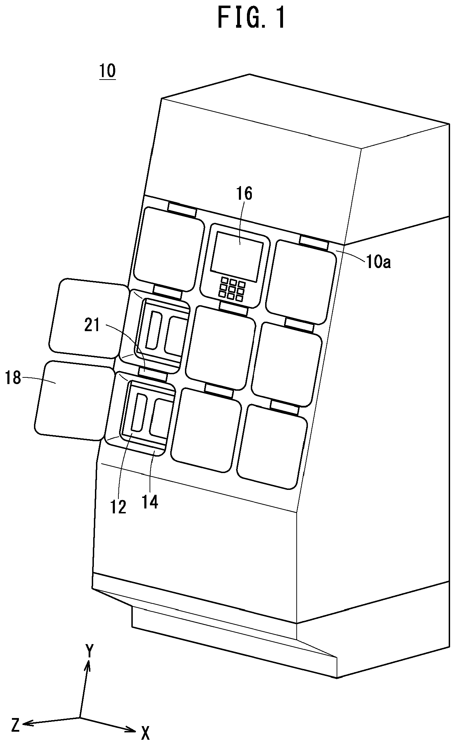

FIG. 1 is an external schematic view of a battery exchanger 10. The battery exchanger 10 stores a mobile battery 12 therein in an insertable and removable manner, and is an apparatus that charges a mobile battery 12. A user stores a mobile battery 12 whose SOC (State Of Charge) has become low in the battery exchanger 10, and the user takes a different mobile battery 12 that has been charged, from the battery exchanger 10. The battery exchanger 10 corresponds to a holding apparatus of the present invention.

The battery exchanger 10 includes eight slots 14 and one operation panel 16. A mobile battery 12 is stored in the slot 14. When the user stores the mobile battery 12 in the slot 14 and closes a door 18, the battery exchanger 10 starts charging the mobile battery 12. An indicator 21 is provided above the slot 14. The indicator 21 indicates the charging state or the like of the mobile battery 12 stored in the slot 14, by causing a light to light up, to blink, or to turn off, by changing the color of the lit-up or blinking light, or the like. The operation panel 16 is an apparatus that is operated by the user. The user makes a payment or the like, for example, by operating the operation panel 16.

The slot 14 opens in a front surface 10a of the battery exchanger 10. The front surface 10a of the battery exchanger 10 is inclined relative to a vertical direction (direction of gravity). In a state where the user is standing in front of and facing the front surface 10a, the distance between the user and the top portion of the front surface 10a is greater than the distance between the user and the bottom portion of the front surface 10a. Due to this, when the user inserts the mobile battery 12 into the slot 14, the user can lean forward, and the mobile battery 12 can be easily inserted into the slot 14.

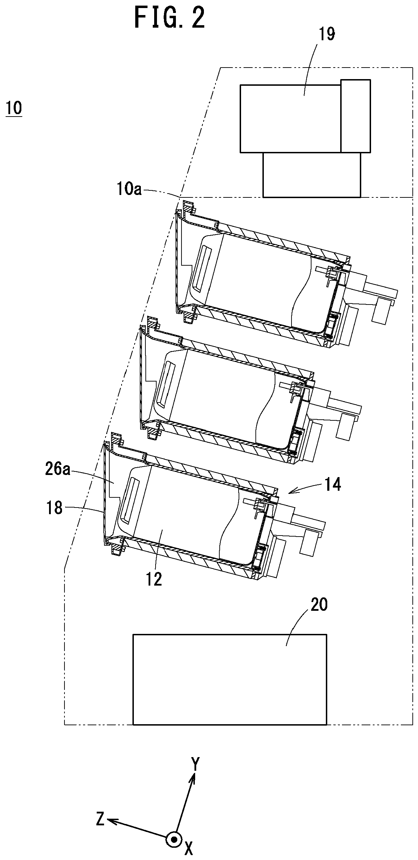

FIG. 2 is a cross-sectional view of the battery exchanger 10. The battery exchanger 10 includes a control apparatus 19 above the slots 14. The control apparatus 19 performs charging control and the like of the mobile battery 12. The battery exchanger 10 includes a utility space 20 below the slots 14. A cooling apparatus can be installed in the utility space 20, for example. The inside of the battery exchanger 10 can be cooled by the cooling apparatus.

The following describes the battery exchanger 10 based on an X-axis, a Y-axis, and a Z-axis defined as shown below. The direction in which the mobile battery 12 is inserted into and removed from the slot 14 is the Z-axis direction, and the direction from the depth of the slot 14 toward the insertion port 26c is the +Z-axis direction. The +Z-axis direction is the direction in which the mobile battery 12 is removed from the slot 14. A direction parallel to the width direction of the battery exchanger 10 is the X-axis direction, and a direction to the right side, when viewed from the side toward which the slot 14 opens in the front surface 10a of the battery exchanger 10, is the +X-axis direction. A direction orthogonal to the Z-axis and the X-axis is the Y-axis direction, and a direction upward is the +Y-axis direction.

In the following, a view from the +Z-axis direction is a front view, a view from the -Z-axis direction is a rear view, a view from the +Y-axis direction is a top view, a view from the-Y-axis direction is a bottom view, a view from the +X-axis direction is a right side view, and a view from the -X-axis direction is a left side view.

### [Overall Configuration of the Slot]

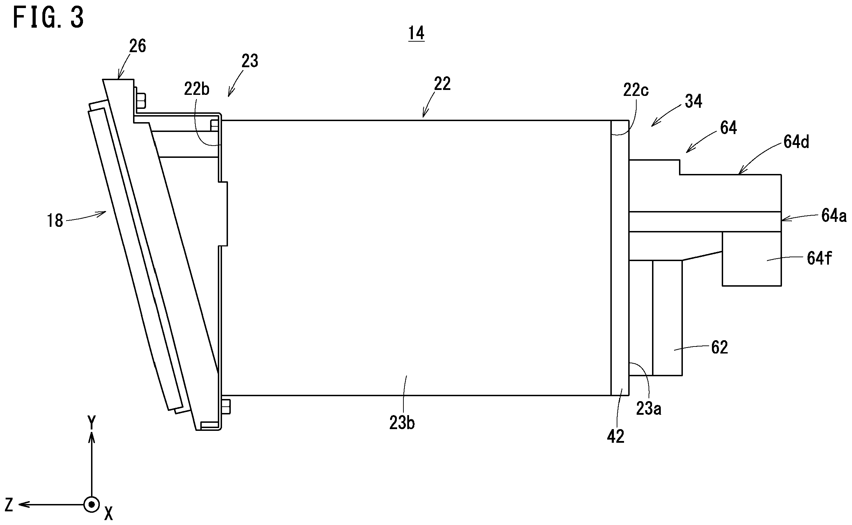

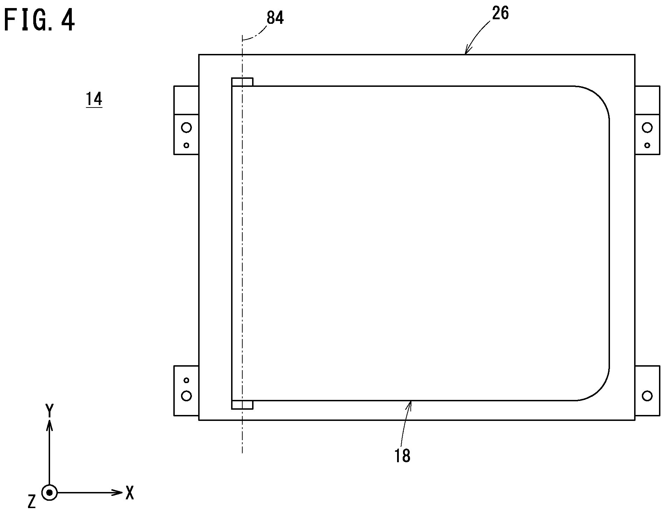

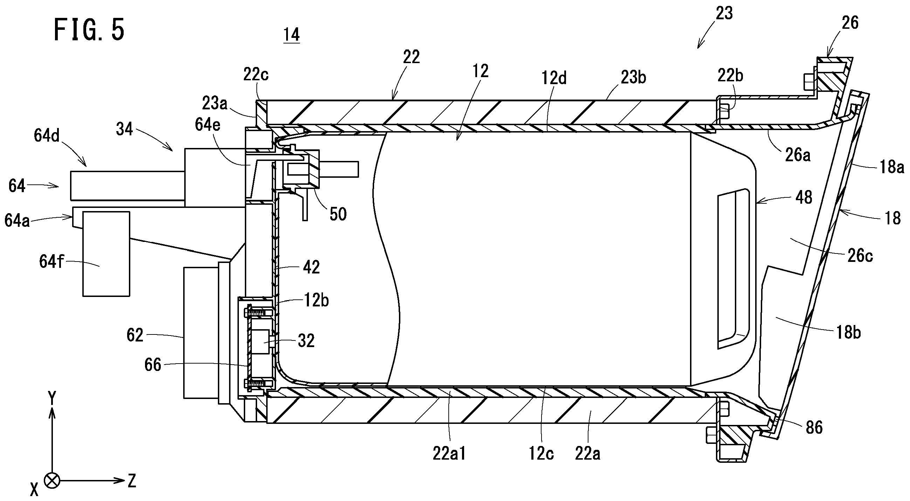

FIG. 3 is a right side view of a slot 14. FIG. 4 is a front view of the slot 14. FIG. 5 is a cross-sectional view of the slot 14. FIG. 5 shows a state in which the mobile battery 12 is inserted into the slot 14. The overall configuration of the slot 14 will be described using FIGS. 3, 4, and 5.

The slot 14 includes a slot sleeve 23. The slot sleeve 23 is shaped as a bottomed tube, and includes a bottom portion 23a and a tubular portion 23b. The slot sleeve 23 holds the mobile battery 12 inserted into the slot 14. The tubular portion 23b surrounds the outer periphery of the mobile battery 12 held in the slot sleeve 23. The slot sleeve 23 includes a slot body 22, a slot flange 26, and a bottom cover 42. The slot 14 corresponds to a holding portion of the present invention. The mobile battery 12 corresponds to an electric device of the present invention. The bottom cover 42 corresponds to a first member of the present invention. The slot body 22 corresponds to a second member of the present invention.

The tubular portion 23b of the slot sleeve 23 is provided to the slot body 22. The slot body 22 is formed of aluminum. The slot body 22 is a tubular member that has four side surfaces and two opening portions. When the slot body 22 is viewed from the Z-axis direction, the external shape of the slot body 22 is formed to be approximately rectangular. The slot body 22 is not limited to being made of aluminum, and may be made of another metal or of resin. By using aluminum for the slot body 22, the durability of the slot body 22 can be increased compared to a case where resin is used for the slot body 22.

As shown in FIGS. 3 and 5, the slot flange 26 is attached to an opening portion 22b on the +Z-axis-direction side of the slot body 22. The slot flange 26 is formed of resin. The slot flange 26 is not limited to being made of resin, and may be made of metal, for example. The slot flange 26 includes a guide portion 26a. As shown in FIG. 5, the rectangular insertion port 26c penetrates through the guide portion 26a in the Z-axis direction. The door 18 is provided at an end portion of the guide portion 26a on the +Z-axis direction side. The door 18 is made of resin. The door 18 is not limited to being made of resin, and may be made of metal, for example.

As shown in FIGS. 3 and 5, the bottom cover 42 is attached to an opening portion 22c, of the slot body 22, on the -Z-axis direction side. The bottom cover 42 is made of resin. The bottom portion 23a of the slot sleeve 23 is provided to the bottom cover 42. The bottom cover 42 is not limited to being made of resin, and may be made of metal, for example. The bottom cover 42 is formed with a rectangular shape, when viewed from the Z-axis direction.

Resin is used for each of the slot flange 26, the door 18, and the bottom cover 42. Due to this, the slot flange 26, door 18, and bottom cover 42 can each be manufactured at a lower cost than in a case where metal is used for each of the slot flange 26, door 18, and bottom cover 42.

The slot body 22 is a member that receives the majority of the weight of the mobile battery 12. Furthermore, the slot body 22 is larger than the slot flange 26, door 18, and bottom cover 42. Therefore, the slot body 22 preferably has higher durability than the slot flange 26, door 18, and bottom cover 42.

When the mobile battery 12 is held in the slot sleeve 23, a holding detection switch 32 is pressed down on by the mobile battery 12, and switches from OFF to ON. A fan 62 sends air to the inside of the slot body 22. A connector unit 64 includes a connector 64e that engages with the connector 50 of the mobile battery 12.

### [Configuration of the Mobile Battery]

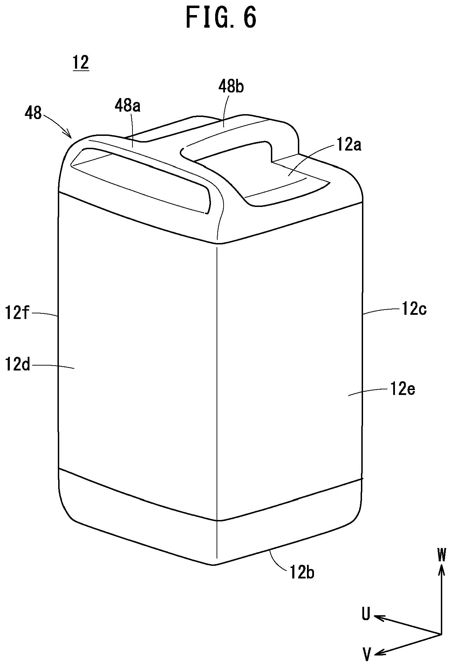

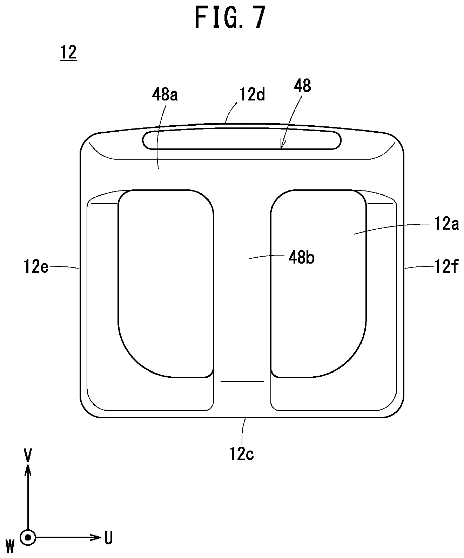

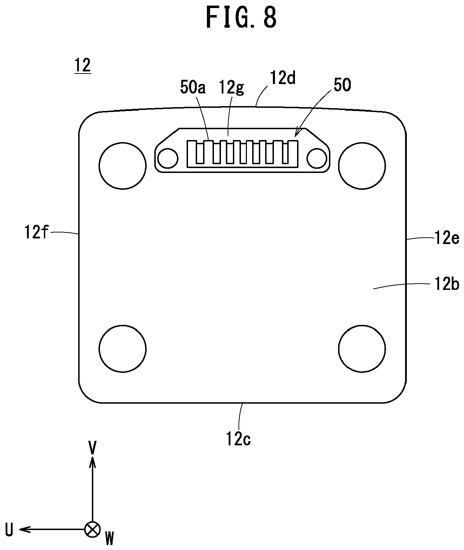

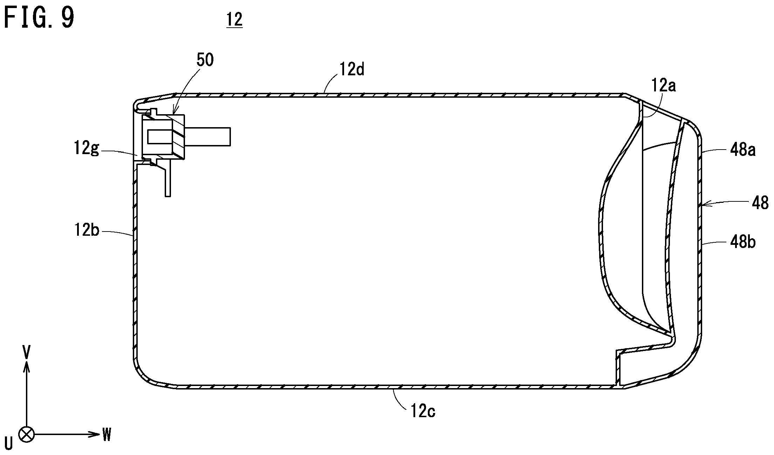

FIG. 6 is a perspective view of the mobile battery 12. FIG. 7 shows the top surface 12a of the mobile battery 12. FIG. 8 shows the bottom surface 12b of the mobile battery 12. FIG. 9 is a cross-sectional view of the mobile battery 12. The following describes the configuration of the mobile battery 12, using FIGS. 6, 7, 8, and 9.

In the following description of the configuration of the mobile battery 12, the U-axis, V-axis, and W-axis defined as shown below are used. The longitudinal direction of the mobile battery 12 is the W-axis direction, and the direction from the bottom surface 12b to the top surface 12a is the +W-axis direction. The direction along which the side surface 12c and side surface 12d of the mobile battery 12 are lined up is the V-axis direction, and the direction from the side surface 12c toward the side surface 12d is the +V-axis direction. The direction in which the side surface 12e and the side surface 12f are lined up is the U-axis direction, and the direction from the side surface 12e toward the side surface 12f is the +U-axis direction.

As shown in FIG. 6, a handle 48 is provided on the top surface 12a of the mobile battery 12. The handle 48 includes a first grip portion 48a that extends in the U-axis direction and a second grip portion 48b that extends in the V-axis direction. The user grips the handle 48 and inserts or removes the mobile battery 12 into or from the slot 14.

As shown in FIGS. 6 and 7, among the side surfaces 12c, 12d, 12e, and 12f of the mobile battery 12, the side surface 12d is a curved surface that protrudes outward. Among the side surfaces 12c, 12d, 12e, and 12f of the mobile battery 12, the side surfaces 12c, 12e, and 12f are approximately flat surfaces.

As shown in FIGS. 8 and 9, the connector 50 (female connector 50) is exposed in the bottom surface 12b of the mobile battery 12 on the -W-axis direction side. The female connector 50 corresponds to a first electric terminal of the present invention. The connector 50 is arranged at a position further toward the +V-axis direction side than the center, in the V-axis direction, of the bottom surface 12b. The connector 50 is provided in a recessed portion 12g of the mobile battery 12. The recessed portion 12g is formed to be depressed further toward the +W-axis direction side than the bottom surface 12b. The connector 50 is positioned further toward the +W-axis direction side than the bottom surface 12b. Due to this, when the mobile battery 12 is placed on a ground surface or the like with the bottom surface 12b at the bottom, contact between the connector 50 and the ground surface or the like can be restricted. Accordingly, the connector 50 can be prevented from getting dirty, being damaged, or the like. Furthermore, the connector 50 can be restricted from contacting a conducive body. Accordingly, unintentional discharge of the mobile battery 12 can be restricted.

### [Configuration of the Slot Body]

The configuration of the slot body 22 will be described using FIG. 5. A slider 22a1 is formed on the inner surface of the lower side plate 22a of the slot body 22 on the -Y-axis direction side. The slider 22a1 extends in the Z-axis direction. The slider 22a1 protrudes with a convex shape in the +Y-axis direction from the surface of the lower side plate 22a. A groove extending in the Z-axis direction is formed in the surface of each slider 22a1. Due to this, the contact surface area between the slider 22a1 and the mobile battery 12 being inserted into or removed from the slot 14 in the Z-axis direction can be reduced. Therefore, friction between the mobile battery 12 and the sliders 22a1 can be decreased.

### [Configuration of the Slot Flange]

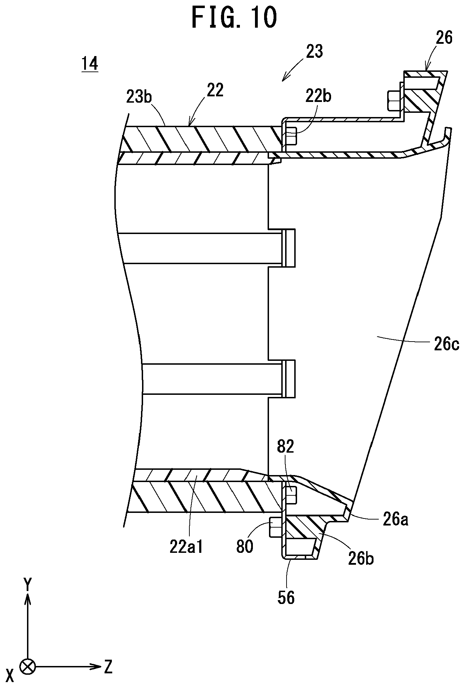

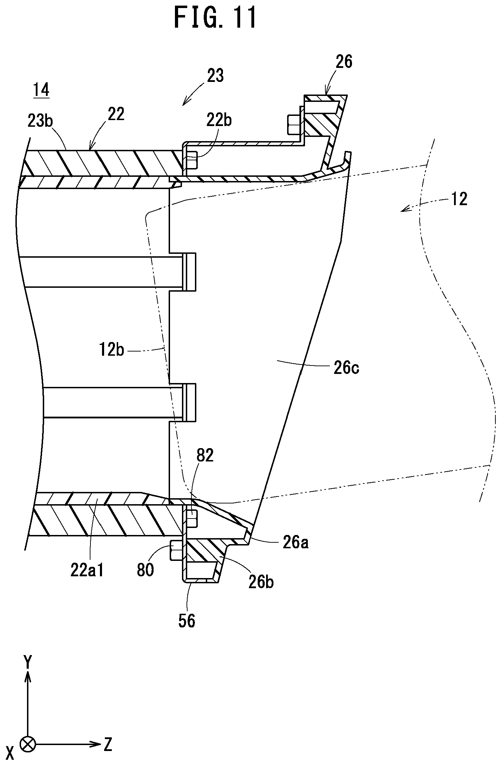

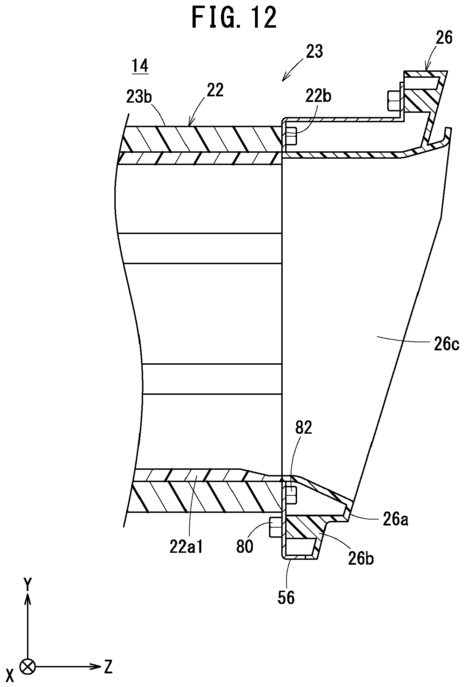

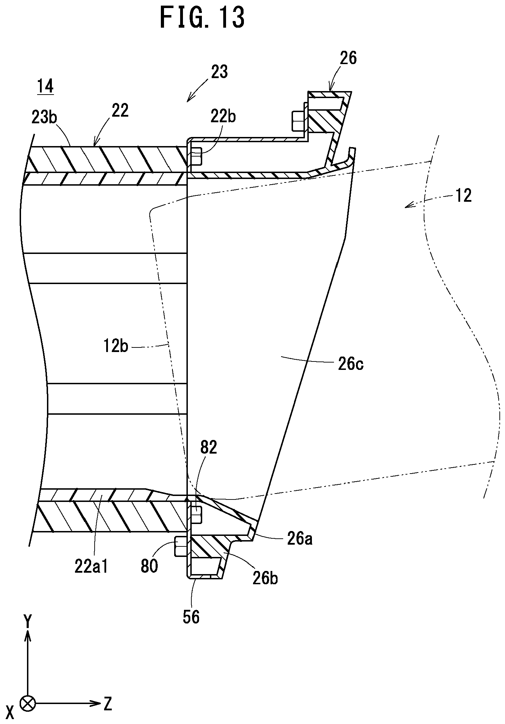

FIGS. 10, 11, 12, and 13 are each a cross-sectional view of the slot 14. FIGS. 10, 11, 12, and 13 show a connection portion where the slot body 22 and the slot flange 26 connect. FIGS. 10 and 11 show the slot 14 of the present embodiment. FIGS. 12 and 13 show a slot 14 of a comparative example. FIGS. 11 and 13 show a state in which the mobile battery 12 is inserted into the slot 14. The configuration of the slot flange 26 will be described using FIGS. 10, 11, 12, and 13.

As shown in FIG. 10, the slot flange 26 includes a guide portion 26a and a flange portion 26b. The guide portion 26a includes the insertion port 26c through which the mobile battery 12 is inserted. As shown in FIG. 10, the area of the opening of the insertion port 26c of the slot flange 26 becomes gradually larger toward the +Z-axis direction. Due to this, when the user inserts the mobile battery 12 into the insertion port 26c in the -Z-axis direction, the mobile battery 12 can be inserted easily into the insertion port 26c.

As shown in FIG. 10, the slot flange 26 is fixed to the slot body 22 via a slot fixing stay 56. The flange portion 26b of the slot flange 26 and the slot fixing stay 56 are fastened to each other by a bolt 80. The end surface of the slot body 22 at the +Z-axis direction side and the slot fixing stay 56 are fastened to each other by a bolt 82.

As shown in FIGS. 10 and 11, the end portion of the slot flange 26 on the -Z-axis direction side is inserted into the inner periphery of the opening portion of the slot body 22 at the +Z-axis direction side. Due to this, the slot flange 26 and the slot body 22 overlap each other in the Z-axis direction. Therefore, the slot flange 26 can be restricted from coming loose from the slot body 22.

As shown in FIG. 11, in a state where the mobile battery 12 is placed on the guide portion 26a of the slot flange 26, the weight of the mobile battery 12 can be received not only by the bolt 80 and the bolt 82, but also by the region where the slot flange 26 and the slot body 22 overlap. In the comparative example shown in FIGS. 12 and 13, the slot flange 26 and the slot body 22 do not overlap in the Z-axis direction. Therefore, in a state where the mobile battery 12 is placed on the guide portion 26a of the slot flange 26, the weight of the mobile battery 12 is received by only the bolt 80 and the bolt 82. In the present embodiment, since the weight of the mobile battery 12 can be received by the region where the slot flange 26 and the slot body 22 overlap as well, the shear force acting on the bolt 80 and the bolt 82 can be reduced.

### [Configuration of the Door]

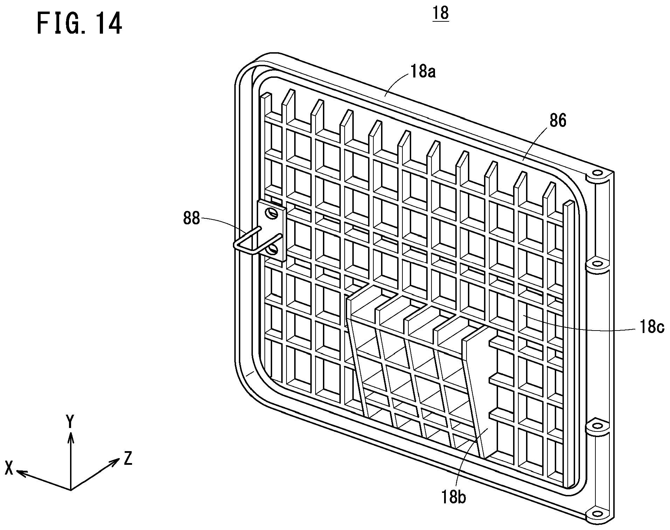

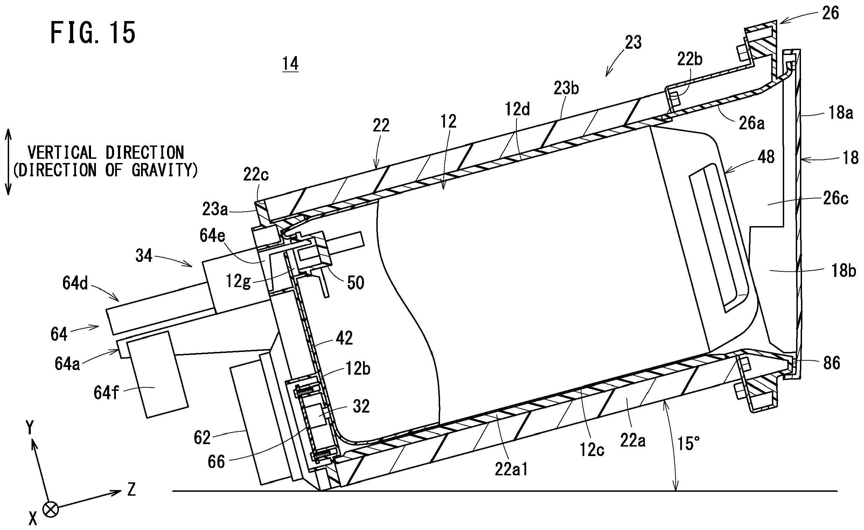

FIG. 14 is a perspective view of the door 18. The directions indicated by the X-axis, Y-axis, and Z-axis shown in FIG. 14 each indicate a direction in a state where the door 18 is closed. FIG. 15 is a cross-sectional view of the slot 14. FIG. 15 shows a state in which the mobile battery 12 is inserted in the slot 14. The insertion and removal direction of the mobile battery 12 (Z-axis direction) shown in FIG. 15 is inclined relative to a horizontal direction. The posture of the slot 14 shown in FIG. 15 is the same as the posture of the slot 14 inside the battery exchanger 10. The configuration of the door 18 will be described using FIGS. 4, 14, and 15.

As shown in FIG. 4, the door 18 pivots centered on a pivoting axial line 84 extending in the Y-axis direction at the end portion of the door 18 on the -X-axis direction side.

As shown in FIG. 14, the door 18 includes a body portion 18a and a protruding portion 18b. The door 18 includes ribs 18c that extend in the X-axis direction and the Y-axis direction, on the surface of the body portion 18a on the -Z-axis direction side. A seal member 86 is provided along the entire outer periphery of the ribs 18c. A catch 88 is provided on the surface of the body portion 18a that faces in the -Z-axis direction. The catch 88 is arranged further toward the +X-axis direction side than the center of the body portion 18a, in the X-axis direction. The catch 88 engages with a snatch lock (not shown in the drawings) provided on the slot flange 26, when the door 18 is in the closed state. The snatch lock is controlled by a control section 67, described further below, to switch between a state in which the door 18 is locked and a state in which the door 18 is unlocked. The protruding portion 18b is provided on the surface of the body portion 18a that faces in the -Z-axis direction. The protruding portion 18b is arranged at a center portion, in the X-axis direction, of the body portion 18a. The protruding portion 18b protrudes from the body portion 18a in the -Z-axis direction.

As shown in FIG. 15, the slot 14 inside the battery exchanger 10 is positioned such that the end portion of the slot 14 on the +Z-axis direction side is positioned above the end portion of the slot 14 on the -Z-axis direction side. Due to this, the Z-axis direction, which is the direction of the insertion and removal of the mobile battery 12, is inclined by approximately 15° relative to the horizontal direction. The body portion 18a of the door 18 is approximately parallel to the vertical direction.

As shown in FIG. 15, in a state where the door 18 is closed, the protruding portion 18b abuts against the handle 48 of the mobile battery 12. Due to this, the door 18 restricts the +Z-axis direction movement of the mobile battery 12 stored in the slot 14. When the mobile battery 12 is inserted into the slot 14 and the door 18 is closed, the connector 64e of the connector unit 64 described further below moves in the +Z-axis direction, and the connector 64e engages with the connector 50 of the mobile battery 12. At this time, a pressing force in the +Z-axis direction acts on the mobile battery 12 from the connector unit 64. On the other hand, the mobile battery 12 is restricted from moving in the +Z-axis direction by the protruding portion 18b. Therefore, it is possible to prevent the connector 64e from disengaging from or only partially engaging with the connector 50 of the mobile battery 12.

As shown in FIG. 15, when the slot 14 is viewed from the - X-axis direction side, an approximately triangular space is created between the mobile battery 12 and the body portion 18a of the door 18. Within this approximately triangular space, the volume of the region on the -Y-axis direction side of the center, in the Y-axis direction, of the approximately triangular space is less than the volume of the region on the +Y-axis direction side of the center of the approximately triangular space. The protruding portion 18b is formed at a position on the -Y-axis direction side of the center, in the Y-axis direction, of the body portion 18a. Therefore, compared to a case where the protruding portion 18b is formed at a position on the +Y-axis direction side of the center, in the Y-axis direction, of the body portion 18a, the volume of the protruding portion 18b can be reduced. Accordingly, it is possible to realize restriction of the movement of the mobile battery 12 with the protruding portion 18b while also restricting an increase in the volume of the door 18.

### [Configuration of the Holding Detection Switch]

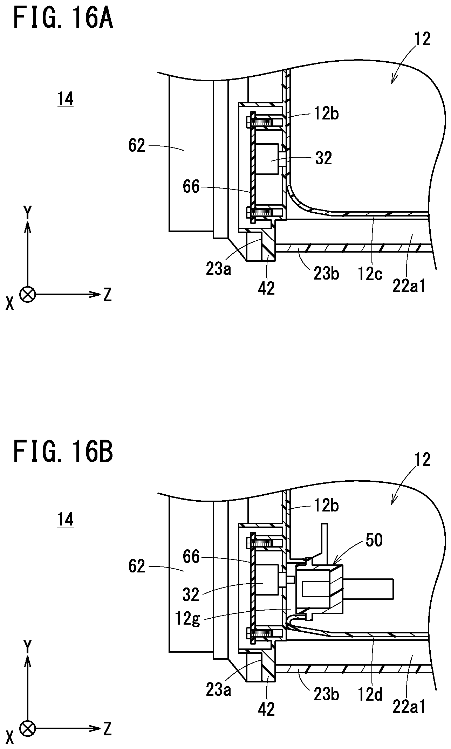

FIGS. 16A and 16B are cross-sectional views of the slot 14. FIGS. 16A and 16B show the slot 14 in a state where the mobile battery 12 is inserted therein. FIGS. 16A and 16B show the structure of the holding detection switch 32 and the slot 14 in the vicinity thereof. The configuration of the holding detection switch 32 will be described using FIGS. 5, 16A, and 16B.

As shown in FIG. 5, the holding detection switch 32 is arranged on the -Y-axis direction side of the center, in the Y-axis direction, of the bottom cover 42. In a state where the side surface 12d faces in the +Y-axis direction, when the mobile battery 12 is inserted into the slot 14, the bottom surface 12b of the mobile battery 12 presses down on the holding detection switch 32, as shown in FIG. 16A. At this time, the holding detection switch 32 switches from OFF to ON. When the holding detection switch 32 switches from OFF to ON, the holding detection switch 32 detects that the mobile battery 12 has been held in the slot sleeve 23.

In a state where the side surface 12d faces in the -Y-axis direction, when the mobile battery 12 is inserted into the slot 14, the holding detection switch 32 is inserted into the recessed portion 12g of the mobile battery 12, as shown in FIG. 16B, and the bottom surface 12b does not abut against the holding detection switch 32. At this time, the holding detection switch 32 remains in the OFF state. When the holding detection switch 32 is OFF, the holding detection switch 32 does not detect that the mobile battery 12 is being held in the slot sleeve 23. The holding detection switch 32 corresponds to a holding detection portion of the present invention.

Since the recessed portion 12g of the mobile battery 12 in which the connector 50 is placed can be used as a structure into which the holding detection switch 32 is inserted, there is no need to provide the mobile battery 12 with a separate structure into which the holding detection switch 32 is inserted. The structure that allows the holding detection switch 32 to be inserted into the mobile battery 12 can also be called a structure for avoiding contact between the mobile battery 12 and the holding detection switch 32.

### [Configuration of the Bottom Cover Assembly]

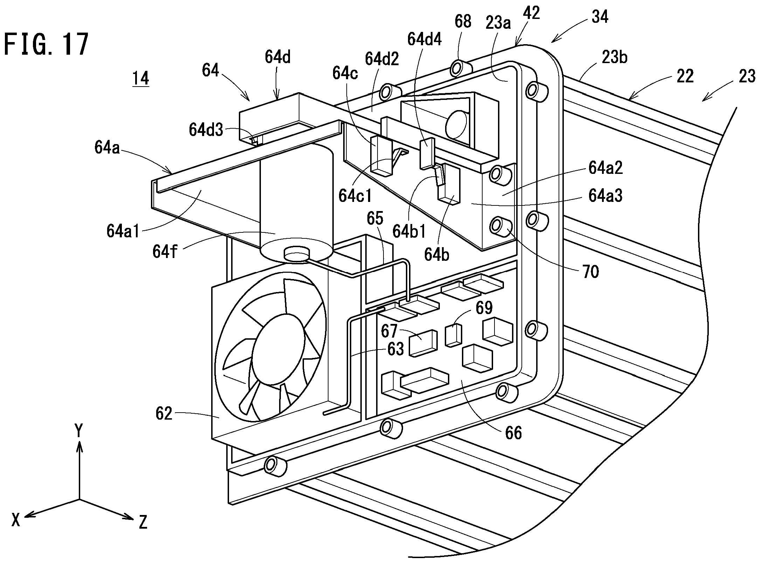

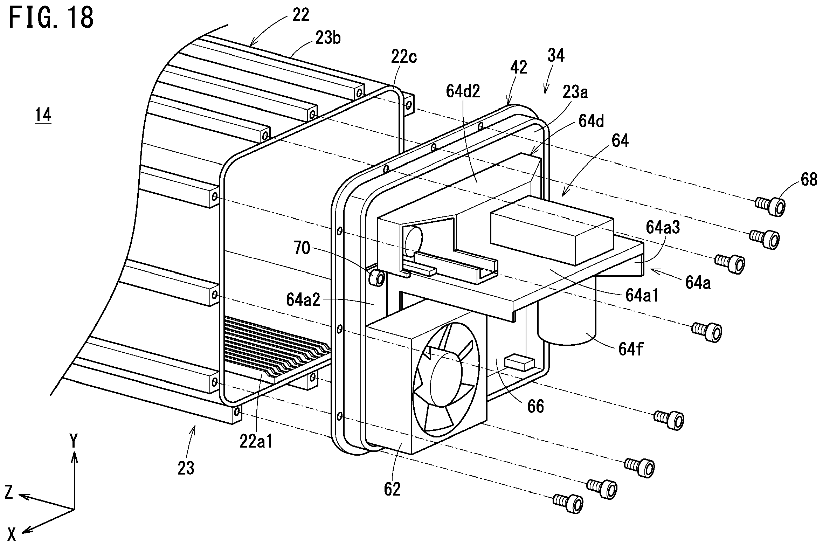

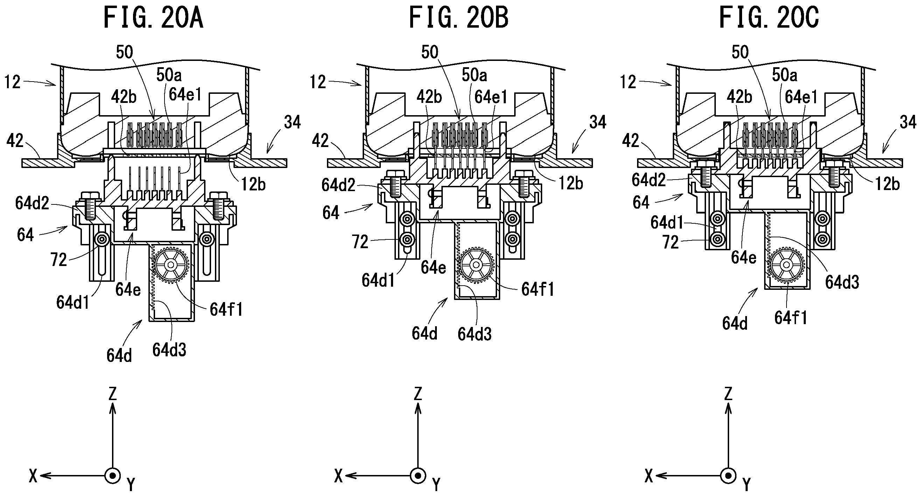

FIGS. 17, 18, and 19 are each a perspective view of the slot 14. FIG. 18 shows a state in which a bottom cover assembly 34 has been removed from the slot body 22. FIGS. 20A, 20B, and 20C are each a cross-sectional view of the bottom cover assembly 34 and the mobile battery 12. The configuration of the bottom cover assembly 34 will be described using FIGS. 5, 17, 18, 19, 20A, 20B, and 20C.

As shown in FIGS. 17, 18, and 19, the fan 62, the connector unit 64, and the electronic circuit board 66 are attached to the bottom portion 23a of the bottom cover 42, to form the bottom cover assembly 34.

The control section 67 and a storage section 69 are mounted on the electronic circuit board 66. The electronic circuit board 66 with the control section 67 and storage section 69 mounted thereon forms a computer. An electronic circuit is formed on the electronic circuit board 66, and the control section 67, the storage section 69, and many other electronic devices and electric devices are mounted on this electronic circuit. The holding detection switch 32 described above is also mounted on the electronic circuit of the electronic circuit board 66. As shown in FIG. 15, the holding detection switch 32 is attached to the surface of the electronic circuit board 66 on the +Z-axis direction side. The holding detection switch 32 is included in the bottom cover assembly 34. The holding detection switch 32 corresponds to an electronic device of the present invention. The fan 62, the connector unit 64, and the electronic circuit board 66 are assembled together with the bottom cover 42. The bottom cover 42 and the opening portion 22c of the slot body 22 on the -Z-axis direction side are fastened together by bolts 68.

The control section 67 performs charging control of the mobile battery 12 inserted in the slot 14. The control section 67 is realized by a processing circuit, for example. The processing circuit is formed by an integrated circuit such as an ASIC (Application Specific Integrated Circuit) or an FPGA (Field-Programmable Gate Array), for example. Alternatively, the processing circuit may be formed by an electronic circuit that includes a discrete device. The processing circuit may be formed by a processor such as a CPU (Central Processing Unit) or a GPU (Graphics Processing Unit), for example. In such a case, the processing circuit is realized by executing a program stored in the storage section 69 with the processor.

The fan 62, the connector unit 64, and the electronic circuit board 66 are assembled together with the bottom cover 42, to form the bottom cover assembly 34. Therefore, when the fan 62, the connector unit 64, and the electronic circuit board 66 malfunction, the entire bottom cover assembly 34 can be replaced along with the bottom cover 42. Due to this, the time for the work of replacing malfunctioning devices can be shortened. Furthermore, since the slot body 22 that has high durability compared to the bottom cover assembly 34 can be reused, the cost of maintaining the battery exchanger 10 can be reduced.

As shown in FIGS. 17 and 18, the fan 62 is attached to the bottom cover 42. By driving the fan 62, air is sent to the inside of the slot body 22. As shown in FIGS. 17 and 18, the electronic circuit board 66 is arranged on the -X-axis direction side of the fan 62. A cable 63 is arranged between the electronic circuit board 66 and the fan 62. A cable 65 is arranged between the electronic circuit board 66 and a motor 64f of the connector unit 64. Due to this, the electronic circuit of the electronic circuit board 66 is electrically connected to the fan 62 and the motor 64f. Electricity is supplied from the electronic circuit board 66 to the fan 62 and the motor 64f. Due to this, the fan 62 and the motor 64f are driven. The fan 62 and the motor 64f correspond to electronic devices of the present invention.

As shown in FIGS. 17, 18, and 19, the connector unit 64 includes a base 64a, a connection detection switch 64b, a disconnection detection switch 64c, a connector holder 64d, the connector 64e, and the motor 64f.

The base 64a is fixed to the bottom portion 23a of the bottom cover 42. The base 64a extends in the -Z-axis direction from the surface of the bottom portion 23a on the -Z-axis direction side. The base 64a may be formed integrally with the bottom cover 42. The base 64a includes a body portion 64a1, two flange portions 64a2, and a switch attachment surface 64a3. The two flange portions 64a2 are formed integrally with the body portion 64a1. One flange portion 64a2 is provided on the +X-axis direction side of the body portion 64a1. The other flange portion 64a2 is provided on the -X-axis direction side of the body portion 64a1. Each flange portion 64a2 is formed extending in the X-axis direction from the end portion of the body portion 64a1 on the +Z-axis direction side. The switch attachment surface 64a3 is formed integrally with the body portion 64a1. The switch attachment surface 64a3 is provided on the -X-axis direction side of the body portion 64a1. The switch attachment surface 64a3 extends in the -Y-axis direction from the end portion of the body portion 64a1 on the -X-axis direction side.

The flange portion 64a2 of the base 64a and the bottom cover 42 are fastened together by a bolt 70. The connection detection switch 64b and the disconnection detection switch 64c are attached to the switch attachment surface 64a3. The connection detection switch 64b and the disconnection detection switch 64c are separated from each other in the Z-axis direction. The connection detection switch 64b is arranged on the +Z-axis direction side and the disconnection detection switch 64c is arranged on the -Z-axis direction side, relative to the center of the switch attachment surface 64a3 in the Z-axis direction. The connection detection switch 64b and the disconnection detection switch 64c are each connected to the electronic circuit board 66 by a wire (not shown in the drawings). The connection detection switch 64b and the disconnection detection switch 64c correspond to electronic devices of the present invention.

The connector holder 64d is attached to the surface of the body portion 64a1 of the base 64a on the +Y-axis direction side. The connector holder 64d includes two guide holes 64d1, a connector attachment portion 64d2, a rack 64d3, and a switch operating element 64d4.

Each guide hole 64d1 is a through-hole, and is formed extending in the Z-axis direction. The two guide holes 64d1 are provided separated from each other in the X-axis direction. Two guide pins 72 are inserted into the respective guide holes 64d1. The guide pins 72 are fixed to the body portion 64a1 of the base 64a. Due to this, the connector holder 64d moves in the Z-axis direction relative to the base 64a.

The connector 64e (male connector 64e) is attached to the connector attachment portion 64d2. The male connector 64e corresponds to a second electric terminal of the present invention. As shown in FIG. 15, the connector 64e is arranged vertically above the holding detection switch 32. Due to this, exposure of the connector 64e to liquid intruding inside the slot 14 can be restricted. The connector 64e engages with the connector 50 of the mobile battery 12. At this time, electricity is supplied from the connector 64e to the mobile battery 12, and the mobile battery 12 is charged.

The rack 64d3 is arranged on the -Z-axis direction side of the connector attachment portion 64d2. The rack 64d3 extends in the Z-axis direction. The +Y-axis direction side of the rack 64d3 is not exposed to the outside. As shown in FIG. 17, the -Y-axis direction side of the rack 64d3 is exposed to the outside.

The switch operating element 64d4 is attached to the side surface of the connector holder 64d on the -X-axis direction side. The switch operating element 64d4 moves in the Z-axis direction, along with the connector holder 64d. The switch operating element 64d4 extends in the -Y-axis direction along the switch attachment surface 64a3 of the base 64a, from the connector holder 64d. The switch operating element 64d4 corresponds to an abutment portion of the present invention.

The motor 64f is attached to the surface of the body portion 64a1 of the base 64a on the -Y-axis direction side. The motor 64f is arranged such that the drive shaft thereof faces in the +Y-axis direction. A portion of the drive shaft is arranged into the connector holder 64d. A pinion 64f1 is attached to the tip of the drive shaft of the motor 64f. The pinion 64f1 meshes with the rack 64d3. Due to this, the motor 64f is mechanically connected to the connector 64e, via the pinion 64f1, the rack 64d3, and the base 64a. The motor 64f, the pinion 64f1, and the rack 64d3 correspond to a drive portion of the present invention. The motor 64f corresponds to an electric machine of the present invention. The pinion 64f1 and the rack 64d3 correspond to a drive force transmission mechanism of the present invention. The base 64a corresponds to an extending portion of the present invention.

The connector 64e and the motor 64f are attached to the bottom portion 23a of the bottom cover 42 via the base 64a. The connector 64e and the motor 64f are supported by the bottom cover 42. Due to this, the connector 64e, the motor 64f, and the bottom cover 42 can be handled integrally.

When the bottom cover 42 is viewed from the -Z-axis direction, the holding detection switch 32, the fan 62, the base 64a, the connection detection switch 64b, the disconnection detection switch 64c, the connector holder 64d, the connector 64e, the motor 64f, the pinion 64f1, the rack 64d3, and the electronic circuit board 66 are arranged in a manner to be contained inside the outer edge of the bottom cover 42. In other words, the holding detection switch 32, the fan 62, the base 64a, the connection detection switch 64b, the disconnection detection switch 64c, the connector holder 64d, the connector 64e, the motor 64f, the pinion 64f1, the rack 64d3, and the electronic circuit board 66 are arranged to be contained within the range of a parallel projection of the outer edge of the bottom cover 42. The parallel projection of the outer edge of the bottom cover 42 is a virtual region obtained by projecting the outer edge of the bottom cover 42 in an extension direction of the slot sleeve 23 (insertion and removal direction of the mobile battery 12, or the Z-axis direction). Due to this, when the bottom cover 42 is attached to the slot body 22, the holding detection switch 32, the fan 62, the base 64a, the connection detection switch 64b, the disconnection detection switch 64c, the connector holder 64d, the connector 64e, the motor 64f, the pinion 64f1, the rack 64d3, and the electronic circuit board 66 can be prevented from interfering with the surrounding members.

The base 64a extends in the -Z-axis direction from the surface of the bottom portion 23a of the bottom cover 42 on the -Z-axis direction side, and therefore many members can be attached to the base 64a.

### [Control of the Slot]

By driving the motor 64f, the connector 64e moves in the Z-axis direction along with the connector holder 64d. When the holding detection switch 32 has switched from OFF to ON, the holding detection switch 32 detects that the mobile battery 12 is held by the slot sleeve 23. In this case, the motor 64f moves the connector 64e in the +Z-axis direction, to bring the connector 64e closer to the connector 50 of the mobile battery 12.

When the holding detection switch 32 has switched from ON to OFF, the holding detection switch 32 detects that the mobile battery 12 has been removed from the slot sleeve 23. In this case, the motor 64f moves the connector 64e in the -Z-axis direction, to move the connector 64e away from the connector 50 of the mobile battery 12.

When the holding detection switch 32 is OFF, the holding detection switch 32 does not detect that the mobile battery 12 is held by the slot sleeve 23. In this case, the motor 64f does not move the connector 64e in the +Z-axis direction, and so the connector 64e does not approach the connector 50 of the mobile battery 12.

FIG. 17 shows a state in which the connector holder 64d is positioned on the most +Z-axis direction side. As shown in FIG. 17, in a state where the connector holder 64d is positioned on the most +Z-axis direction side, the switch operating element 64d4 abuts against a movable contact piece 64b1 of the connection detection switch 64b, and presses the movable contact piece 64b1 in the +Z-axis direction. Due to this, the connection detection switch 64b is turned ON. The position of the connector 64e at this time is a connection position. The connection detection switch 64b detects that the connector 64e is at the connection position, and that the connector 64e is connected to the connector 50 of the mobile battery 12. The connection detection switch 64b corresponds to a connection detecting portion of the present invention.

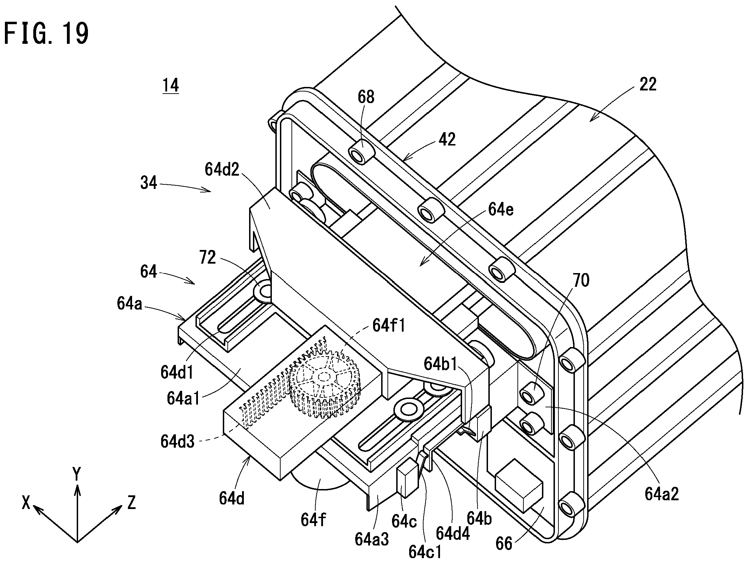

FIG. 19 shows a state in which the connector holder 64d is positioned on the most -Z-axis direction side. As shown in FIG. 19, in a state where the connector holder 64d is positioned on the -Z-axis direction side, the switch operating element 64d4 abuts against a movable contact piece 64c1 of the disconnection detection switch 64c, and presses the movable contact piece 64c1 in the -Z-axis direction. Due to this, the disconnection detection switch 64c is turned ON. The position of the connector 64e at this time is a disconnection position. The disconnection detection switch 64c detects that the connector 64e is at the disconnection position, and that the connector 64e is disconnected from the connector 50 of the mobile battery 12. The disconnection detection switch 64c corresponds to a disconnection detecting portion of the present invention.

FIG. 20A shows a state in which the connector 64e is positioned at the disconnection position. When the connector 64e is positioned at the disconnection position, as shown in FIG. 20A, the tip of the terminal 64e1 of the connector 64e is positioned further toward the -Z-axis direction side than the connector 50. At this time, the disconnection detection switch 64c is ON and the connection detection switch 64b is OFF.

FIG. 20B shows a state in which the connector 64e has moved in the +Z-axis direction from the disconnection position. As shown in FIG. 20B, when the connector 64e moves in the +Z-axis direction from the disconnection position, the tip of the terminal 64e1 passes through a connector insertion hole 42b of the bottom cover 42, and is inserted into a terminal hole 50a of the connector 50 of the mobile battery 12. At this time, the disconnection detection switch 64c and the connection detection switch 64b are both OFF.

FIG. 20C shows a state when the connector 64e is positioned at the connection position. As shown in FIG. 20C, when the connector 64e is positioned at the connection position, connection between the connector 64e and the connector 50 of the mobile battery 12 is complete. At this time, the disconnection detection switch 64c is OFF and the connection detection switch 64b is ON.

When the connector 64e is moving in a direction toward the connector 50 of the mobile battery 12, if the connection detection switch 64b detects that the connector 64e and the connector 50 have been connected, the control section 67 controls the motor 64f to stop the connector 64e. When the connector 64e is moving in a direction away from the connector 50 of the mobile battery 12, if the disconnection detection switch 64c detects that the connector 64e has been disconnected from the connector 50, the control section 67 controls the motor 64f to stop the connector 64e.

When the holding detection switch 32 has detected that the mobile battery 12 is held in the slot sleeve 23 and the connection detection switch 64b has detected that the connector 64e and the connector 50 of the mobile battery 12 are connected, the control section 67 allows usage of the mobile battery 12. Specifically, the control section 67 performs charging control of the mobile battery 12, to charge the mobile battery 12.

If the holding detection switch 32 does not detect that the mobile battery 12 is held in the slot sleeve 23, or the connection detection switch 64b does not detect that the connector 64e and the connector 50 of the mobile battery 12 are connected, the control section 67 prohibits usage of the mobile battery 12. Specifically, the control section 67 does not perform charging control of the mobile battery 12, and does not charge the mobile battery 12.

If the disconnection detection switch 64c detects that the connector 64e has been disconnected from the connector 50 of the mobile battery 12, the control section 67 allows the mobile battery 12 to be removed from the slot sleeve 23. Specifically, the control section 67 unlocks the door 18, to realize a state in which the user can open the door 18.

If the disconnection detection switch 64c does not detect that the connector 64e is disconnected from the connector 50 of the mobile battery 12, the control section 67 prohibits removal of the mobile battery 12 from the slot sleeve 23. Specifically, the control section 67 locks the door 18 or keeps the door 18 locked, to realize a state in which the user cannot open the door 18.

With the connector unit 64 of the present embodiment, by driving the motor 64f, the connector 64e is moved from the disconnection position to the connection position, and the connector 64e is moved from the connection position to the disconnection position.

In the connector unit 64, a first aspect or a second aspect described below, in which the connector 64e is moved using the elastic bias force of a spring or the like, may be adopted. In the first aspect, the connector 64e is moved from the disconnection position to the connection position by driving the motor 64f, and the connector 64e is moved from the connection position to the disconnection position by the elastic bias force of the spring or the like. In the second aspect, the connector 64e is moved from the disconnection position to the connection position by the elastic bias force of the spring or the like, and the connector 64e is moved from the connection position to the disconnection position by driving the motor 64f.

In the connector unit 64, the connector 64e may be moved using the force generated when the user closes the door 18.

In the connector unit 64, the connector 64e may be moved using the weight of the mobile battery 12.

### [Second Embodiment]

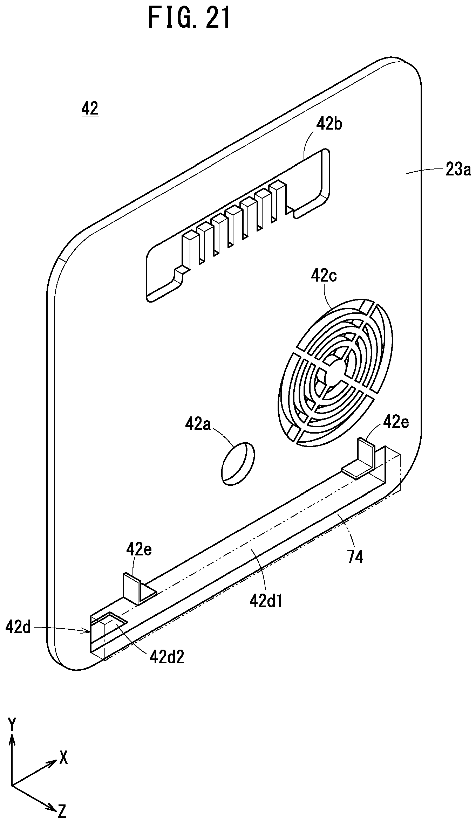

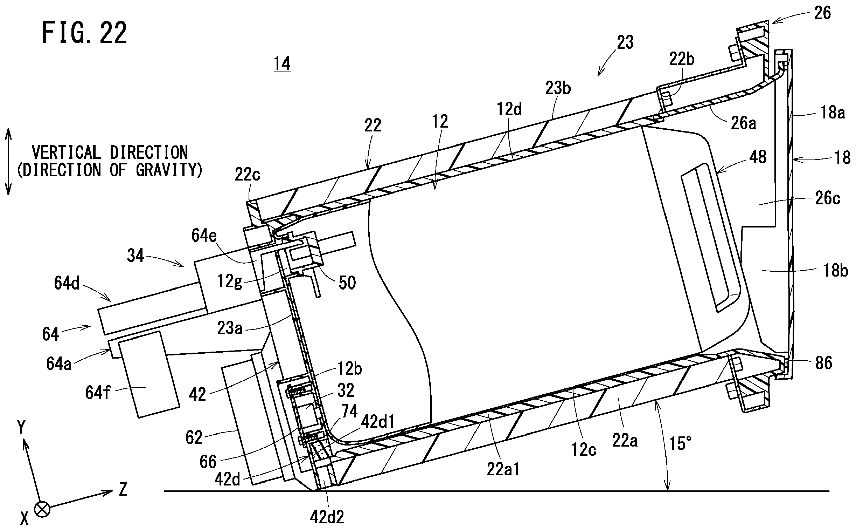

The battery exchanger 10 of the present embodiment includes a mechanism that discharges liquid such as rain water to the outside from the inside of the slot 14. FIG. 21 is a perspective view of the bottom cover 42. FIG. 22 is a cross-sectional view of the slot 14. FIG. 22 shows a state in which the mobile battery 12 is inserted in the slot 14.

As shown in FIG. 21, the bottom cover 42 includes a switch hole 42a, a connector insertion hole 42b, an air inflow port 42c, and a water discharge path 42d. The switch hole 42a, the connector insertion hole 42b, the air inflow port 42c, and the water discharge path 42d correspond to communication paths of the present invention.

The holding detection switch 32 is attached in the switch hole 42a from the -Z-axis direction side. A portion of the holding detection switch 32 passes through the switch hole 42a to be exposed on the +Z-axis direction side of the bottom cover 42. When the connector 64e has moved in the +Z-axis direction, the tip of the connector 64e passes through the connector insertion hole 42b to be exposed on the +Z-axis direction side of the bottom cover 42. The air inflow port 42c and the water discharge path 42d allow the outside and the inside of the slot 14 to communicate with each other.

The fan 62 is attached to the -Z-axis direction side of the air inflow port 42c. By driving the fan 62, air is sent to the inside of the slot sleeve 23 from the air inflow port 42c. Due to this, the flow of air between the outside and the inside of the slot sleeve 23 is facilitated. The fan 62 corresponds to a blowing portion of the present invention.

The water discharge path 42d discharges liquid such as rain water to the outside from inside the slot 14. The water discharge path 42d is arranged further toward the -Y-axis direction side than the air inflow port 42c and the switch hole 42a. Due to this, as shown in FIG. 22, the water discharge path 42d is arranged vertically below the fan 62 and the holding detection switch 32.

The water discharge path 42d is formed from a first water discharge path 42d1 and a second water discharge path 42d2. As shown in FIG. 22, the portion of the bottom cover 42 that is further on the -Y-axis direction side than the position where the holding detection switch 32 is attached has a recessed shape that is recessed in the -Z-axis direction. The portion having this recessed shape extends in the X-axis direction, as shown in FIG. 21. The portion having this recessed shape forms the first water discharge path 42d1. An opening portion that opens in the Y-axis direction is formed in the end portion of the first water discharge path 42d1 on the -X-axis direction side. This opening portion forms the second water discharge path 42d2.

A filtering member 74 is attached to the first water discharge path 42d1. The filtering member 74 is fitted in the first water discharge path 42d1 having a recessed shape. The filtering member 74 is attachable to and detachable from the first water discharge path 42d1. Two ribs 42e are formed further on the +Y-axis direction side than the first water discharge path 42d1. A portion of the filtering member 74 sticking out from the first water discharge path 42d1 is held down in the -Y-axis direction by these two ribs 42e. The filtering member 74 may be a porous member such as a sponge filter, for example.

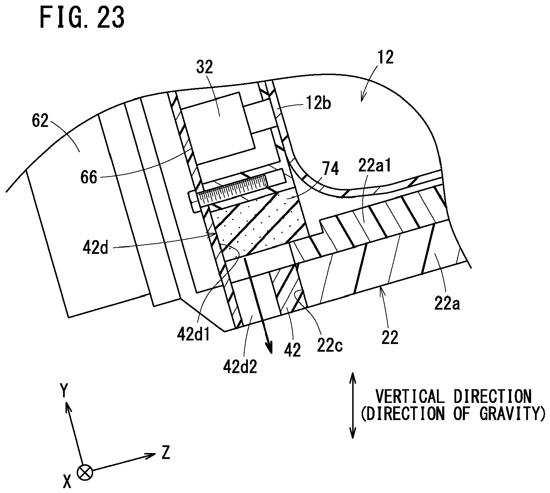

FIG. 23 is a cross-sectional view of the slot 14. FIG. 23 is an enlarged view of the water discharge path 42d and the surrounding region. FIG. 23 shows a state in which the mobile battery 12 is inserted in the slot 14.

As shown by the arrows in FIG. 23, liquid that has entered inside the slot 14 from the insertion port 26c of the slot 14 passes through the filtering member 74 of the first water discharge path 42d1, and is discharged to the outside of the slot 14 from the second water discharge path 42d2. By providing the filtering member 74 in the first water discharge path 42d1, the flow of liquid is dispersed or decelerated while passing through the filtering member 74. Due to this, it is possible to avoid forceful discharge or gushing of the liquid from the slot 14.

There may be cases where solid debris such as dust, fallen leaves, paper, or the like intrudes into the slot 14 from the insertion port 26c of the slot 14. By providing the filtering member 74 in the first water discharge path 42d1, debris can be contained inside the slot 14. The debris contained inside the slot 14 can be removed along with the filtering member 74.

Since the air inflow port 42c and the water discharge path 42d are formed in the bottom portion 23a of the bottom cover 42, in a state where the bottom cover 42 has been removed from the slot body 22, cleaning or the like of the air inflow port 42c and the water discharge path 42d can be performed.

### [Third Embodiment]

The battery exchanger 10 of the present embodiment includes a mechanism that restricts liquid such as rain water, solid debris such as dust, and the like from intruding inside the holding detection switch 32.

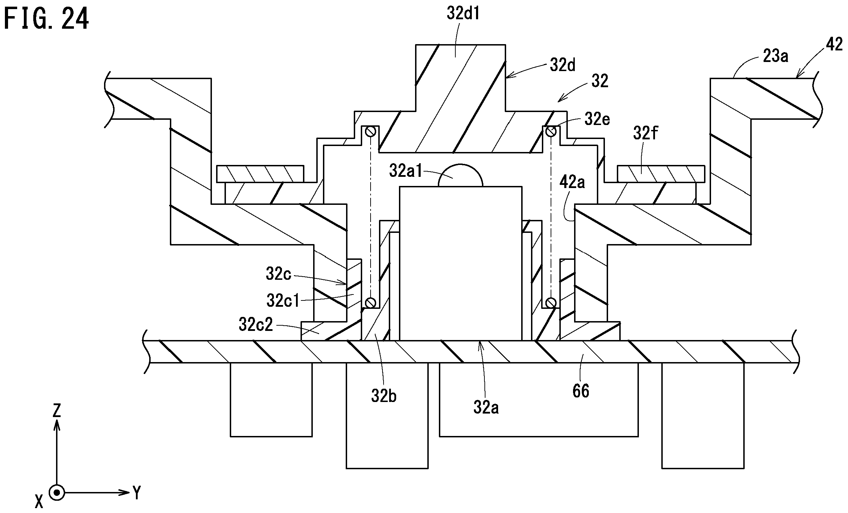

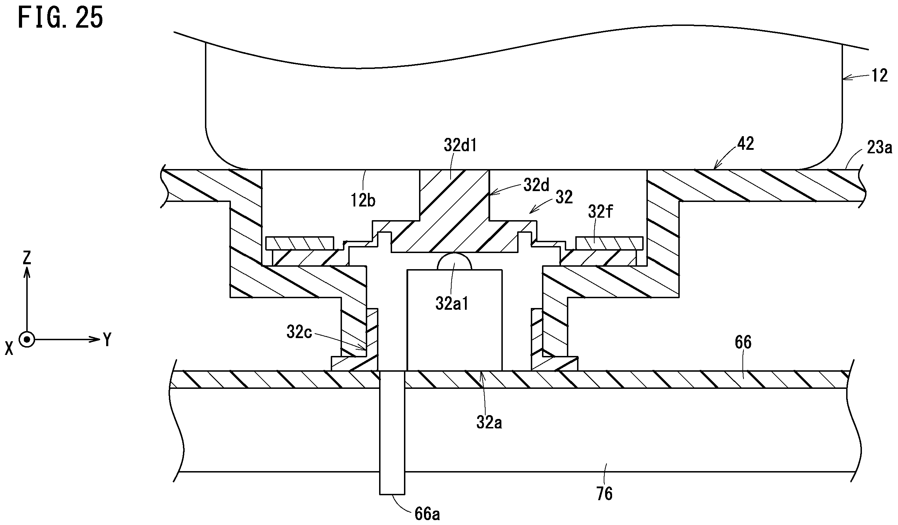

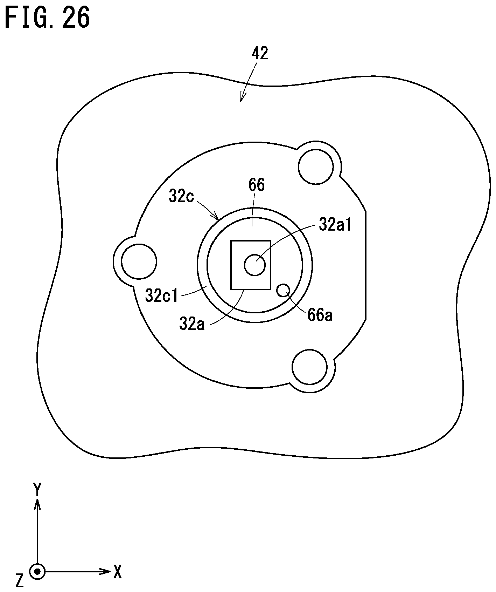

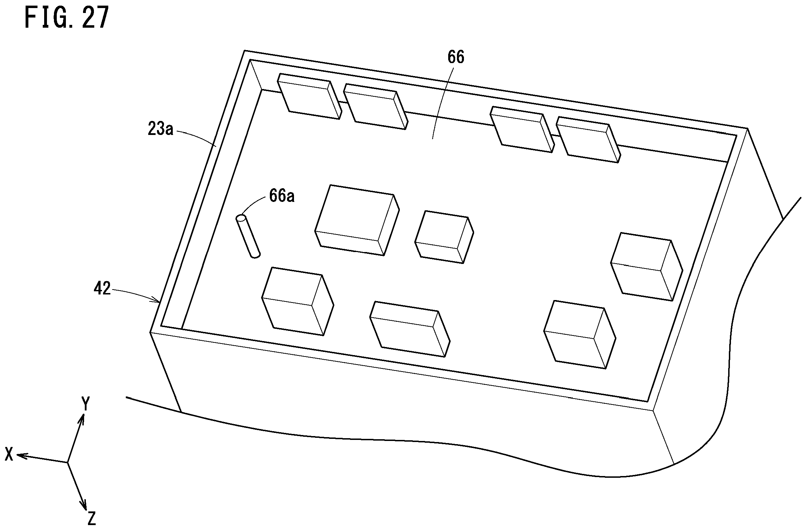

FIG. 24 is a cross-sectional view of the holding detection switch 32 and the surrounding region. FIG. 25 is a schematic view of the holding detection switch 32. FIG. 25 shows a state in which the mobile battery 12 is held in the slot sleeve 23. In FIG. 25, in order to make the drawing easy to view, a collar 32b and a coil spring 32e, which are described further below, are omitted. FIG. 26 is a planar view of the holding detection switch 32 and the surrounding region. FIG. 26 shows the holding detection switch 32 as seen from the +Z-axis direction. FIG. 26 shows a state in which a switch rubber 32d, described further below, has been removed. FIG. 27 is a perspective view of the electronic circuit board 66 and the surrounding region. In FIG. 27, in order to make the drawing easy to view, a molding 76 is omitted.

As shown in FIG. 24, the holding detection switch 32 includes a switch body 32a, the collar 32b, a seal rubber 32c, the switch rubber 32d, and the coil spring 32e.

The switch body 32a is attached to the electronic circuit board 66. The switch body 32a includes a plunger 32a1. By moving the plunger 32a1 in the -Z-axis direction, the holding detection switch 32 becomes ON.

The collar 32b is a member made of resin, and is formed with a cylindrical shape. The switch body 32a is inserted into the inner circumference of the collar 32b.

The seal rubber 32c includes a cylinder portion 32c1 and a flange portion 32c2. The switch body 32a is inserted, along with the collar 32b, into the inner circumference of the cylinder portion 32c1 of the seal rubber 32c. The switch body 32a is inserted, along with the collar 32b and the seal rubber 32c, into the switch hole 42a, from the -Z-axis direction. At this time, the flange portion 32c2 of the seal rubber 32c is sandwiched between the electronic circuit board 66 and the bottom cover 42. Due to this, liquid such as rain water and solid debris such as dust are restricted from intruding into the holding detection switch 32 from the -Z-axis direction.

The switch rubber 32d includes a protruding portion 32d1 at a center thereof. The switch rubber 32d is attached to the bottom cover 42 from the +Z-axis direction. The switch rubber 32d is fixed to the bottom cover 42 together with a clasp 32f by screws (not shown in the drawings). The switch rubber 32d closes the opening on the +Z-axis direction side of the switch hole 42a. Due to this, liquid such as rain water and solid debris such as dust are restricted from intruding into the holding detection switch 32 from the +Z-axis direction.

The coil spring 32e is provided between the switch rubber 32d and the collar 32b. The coil spring 32e biases the switch rubber 32d in the +Z-axis direction.

As shown in FIG. 25, when the mobile battery 12 is held in the slot sleeve 23, the protruding portion 32d1 of the switch rubber 32d is pressed on in the -Z-axis direction by the bottom surface 12b of the mobile battery 12. After this, the protruding portion 32d1 presses the plunger 32a1 of the switch body 32a in the -Z-axis direction. Due to this, the holding detection switch 32 becomes ON.

As shown in FIGS. 25 to 27, a ventilation hole 66a is provided in the electronic circuit board 66. The ventilation hole 66a is a cylindrical member. As shown in FIG. 26, the ventilation hole 66a is arranged in the inner circumference of the cylinder portion 32c1 of the seal rubber 32c. As shown in FIGS. 25 and 26, the ventilation hole 66a is arranged on the -Y-axis direction side of the switch body 32a. As shown in FIG. 25, the +Z-axis direction side of the ventilation hole 66a is positioned on the -Z-axis direction side of the center of the switch body 32a in the Z-axis direction. The surface of the electronic circuit board 66 that faces in the -Z-axis direction is completely covered by the molding 76. The -Z-axis direction side of the ventilation hole 66a is arranged at a position protruding beyond the molding 76 toward the -Z-axis direction side.

The inside of the holding detection switch 32 is prevented from having a negative pressure, by the ventilation hole 66a. Due to this, when the mobile battery 12 is removed from the slot sleeve 23, the shape of the switch rubber 32d can quickly return to normal.

Furthermore, the ventilation hole 66a is arranged on the-Y-axis direction side of the switch body 32a. That is, in the vertical direction, the ventilation hole 66a is arranged below the switch body 32a. Due to this, when liquid has intruded inside the holding detection switch 32 from the ventilation hole 66a, exposure of the switch body 32a to water can be prevented.

### [Fourth Embodiment]

The battery exchanger 10 of the present embodiment differs from the battery exchanger 10 of the first embodiment with regard to the configurations of the switch operating element 64d4, the connection detection switch 64b, and the disconnection detection switch 64c.

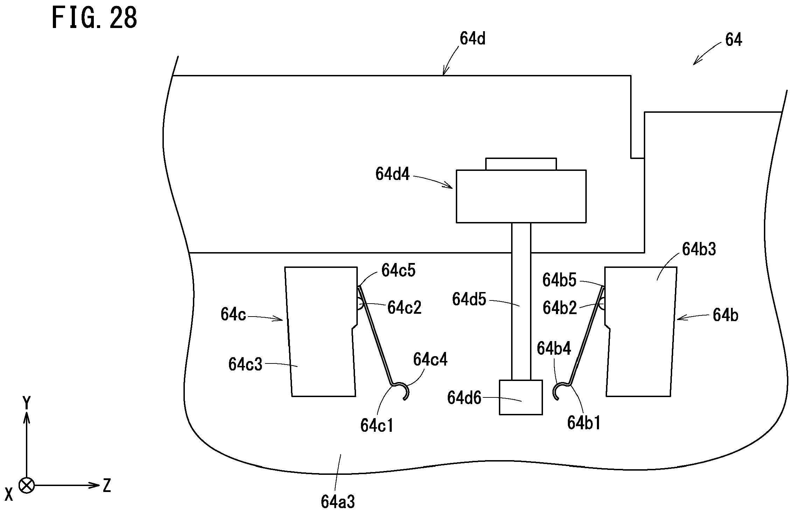

FIG. 28 is a planar view of the connector unit 64. FIG. 28 shows the connector unit 64 as seen from the -X-axis direction. As shown in FIG. 28, the switch operating element 64d4 includes an extending portion 64d5 and an abutting portion 64d6. The extending portion 64d5 extends in the -Y-axis direction along the switch attachment surface 64a3 of the base 64a, from the connector holder 64d. The abutting portion 64d6 is provided at the tip of the extending portion 64d5 at the -Y-axis direction side. The abutting portion 64d6 extends toward both sides in the Z-axis direction, relative to the extending portion 64d5.

The connection detection switch 64b includes the movable contact piece 64b1, a plunger 64b2, and a switch body 64b3. When the switch operating element 64d4 moves in the +Z-axis direction, the abutting portion 64d6 of the switch operating element 64d4 abuts against the tip 64b4 of the movable contact piece 64b1. After this, the movable contact piece 64b1 rotates centered on a fulcrum 64b5 of the movable contact piece 64b1, to press the plunger 64b2. Due to this, the connection detection switch 64b becomes ON. As shown in FIG. 28, when viewed from the -X-axis direction, the connection detection switch 64b is fixed to the switch attachment surface 64a3 of the base 64a, in a state where the switch body 64b3 is inclined in a clockwise rotational direction.

The disconnection detection switch 64c includes the movable contact piece 64c1, a plunger 64c2, and a switch body 64c3. When the switch operating element 64d4 moves in the -Z-axis direction, the abutting portion 64d6 of the switch operating element 64d4 abuts against the tip 64c4 of the movable contact piece 64c1. After this, the movable contact piece 64c1 rotates centered on the fulcrum 64c5 of the movable contact piece 64c1, to press the plunger 64c2. Due to this, the disconnection detection switch 64c becomes ON. As shown in FIG. 28, when viewed from the -X-axis direction, the disconnection detection switch 64c is fixed to the switch attachment surface 64a3 of the base 64a, in a state where the switch body 64c3 is inclined in a counterclockwise rotational direction.

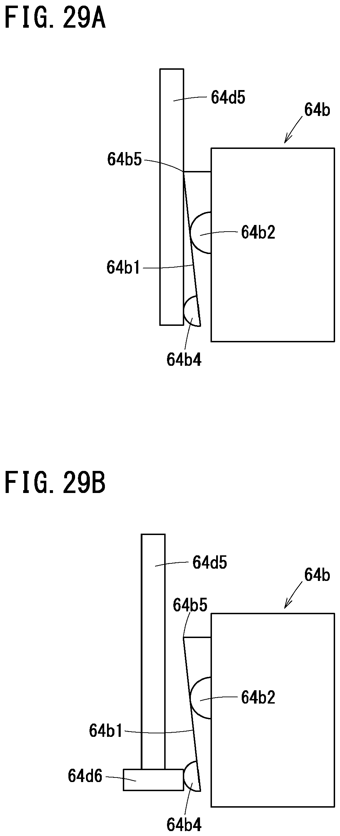

FIGS. 29A and 29B are each a schematic view of the connection detection switch 64b and the switch operating element 64d4. FIGS. 29A and 29B each show a state in which the switch operating element 64d4 is stopped at a position closer to the connection detection switch 64b than a prescribed position. FIG. 29A shows a comparative example in which the abutting portion 64d6 is not provided to the tip of the extending portion 64d5 of the switch operating element 64d4. FIG. 29B shows the battery exchanger 10 of the present embodiment in which the abutting portion 64d6 is provided to the tip of the extending portion 64d5 of the switch operating element 64d4.

As described above, due to the connection detection switch 64b becoming ON, the connection detection switch 64b detects that the connector 64e and the connector 50 of the mobile battery 12 have been connected. When the connector 64e moves in a direction toward the connector 50 of the mobile battery 12, if the connection detection switch 64b has detected that the connector 64e and the connector 50 are connected, the control section 67 controls the motor 64f to stop the connector 64e.

Even when the connector 64e is caused to be stopped, there are cases where the connector 64e is moved by inertial force and the switch operating element 64d4 stops at a position that is closer to the connection detection switch 64b than the prescribed position.

In such a case, in the comparative example shown in FIG. 29A, the extending portion 64d5 contacts the fulcrum 64b5 of the movable contact piece 64b1 of the connection detection switch 64b. Therefore, there is a concern that, for example, the fulcrum 64b5 will be plastically deformed, and even if the switch operating element 64d4 moves away from the movable contact piece 64b1, the movable contact piece 64b1 will not return to its initial position.

On the other hand, in the battery exchanger 10 of the present embodiment shown in FIG. 29B, the extending portion 64d5 is stopped at a position away from the fulcrum 64b5 of the movable contact piece 64b1. Therefore, when the switch operating element 64d4 moves away from the movable contact piece 64b1, the movable contact piece 64b1 can return to the initial position.

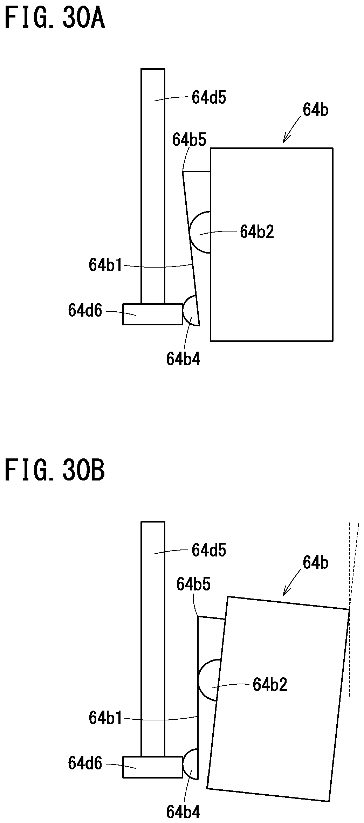

FIGS. 30A and 30B are each a schematic view of the connection detection switch 64b and the switch operating element 64d4. FIGS. 30A and 30B show a state in which the switch operating element 64d4 is stopped at a position closer to the connection detection switch 64b than the prescribed position. FIG. 30A shows a comparative example in which the connection detection switch 64b is fixed to the switch attachment surface 64a3 of the base 64a without being inclined. FIG. 30B shows the battery exchanger 10 of the present embodiment in which the connection detection switch 64b is fixed to the switch attachment surface 64a3 of the base 64a at an incline.

As shown in FIG. 30B, with the battery exchanger 10 of the present embodiment, even when the switch operating element 64d4 stops at a position closer to the connection detection switch 64b than the prescribed position, the extending portion 64d5 can be further separated from the fulcrum 64b5 of the movable contact piece 64b1 of the connection detection switch 64b, compared to the case of the comparative example 30A. Therefore, when the switch operating element 64d4 moves away from the movable contact piece 64b1, the movable contact piece 64b1 can return to the initial position.

With the battery exchanger 10 of the present embodiment, the movable contact piece 64c1 of the disconnection detection switch 64c can also return to the initial position in the same manner as the movable contact piece 64b1 of the connection detection switch 64b.

### [Fifth Embodiment]

In the battery exchanger 10 of the present embodiment, the shape of the bottom cover 42 differs from that of the battery exchanger 10 of the first embodiment.

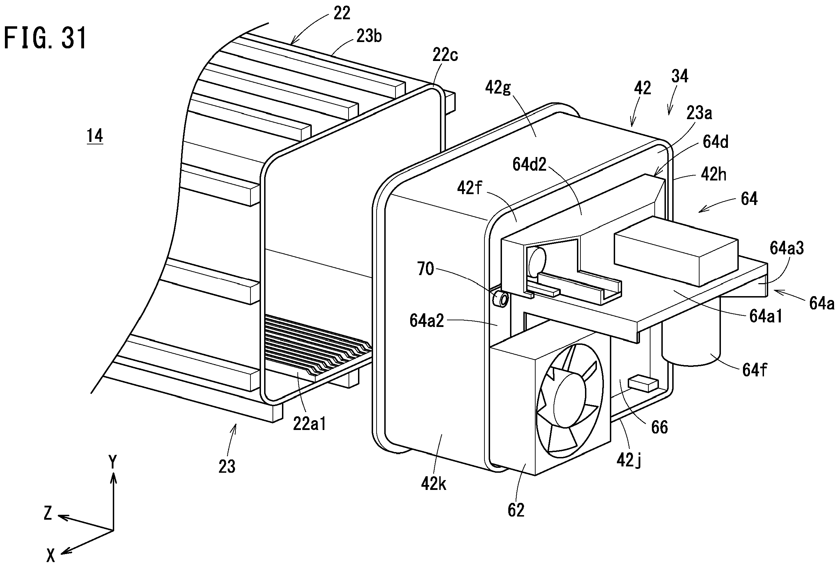

FIG. 31 is a perspective view of the slot 14. FIG. 31 shows a state in which the bottom cover assembly 34 has been removed from the slot body 22.

The bottom cover 42 includes one bottom surface 42f and four side surfaces 42g, 42h, 42j, and 42k. The bottom surface 42f is formed as a rectangle, when viewed from the -Z-axis direction. As shown in FIG. 31, the side surfaces 42g, 42h, 42j, and 42k each extend in the +Z-axis direction respectively from the four edges of the bottom surface 42f. The position at which the slot body 22 and the bottom cover 42 are divided can be set as desired.

In the first to fifth embodiments described above, the slots 14 of the battery exchanger 10 that charges the mobile battery 12 have been described. However, the slots 14 of the first to fifth embodiments may be applied to another apparatus.

In the first to fourth embodiments described above, each slot 14 is a device that stores the mobile battery 12 serving as an electric device. However, the mobile battery 12 and a power converter may be included inside the slot 14, and a power supply device (battery power source) capable of supplying electric power to the outside may be stored therein. Furthermore, the slot 14 may be a device that stores some other electric device.

As an example, the slot 14 may be applied to a stationary power supply apparatus installed in houses, buildings, factories, or the like. Furthermore, the slot 14 may be applied to moving bodies such as automobiles, aircraft, or ships. In a case where the slot 14 is applied to such a stationary power supply apparatus, such a moving body, or the like, the mobile battery 12 inserted in the slot 14 supplies electric power by discharging and is also charged by the stationary power supply apparatus, moving body, or the like.

In the first to fifth embodiments described above, the slot sleeve 23 covers the entire mobile battery 12 being held. However, the slot sleeve 23 may be a member that covers a portion of the mobile battery 12 being held.

In the first to fifth embodiments described above, when the connector 64e of the connector unit 64 has moved in the +Z-axis direction, the tip of the connector 64e passes through the connector insertion hole 42b, to be exposed on the +Z-axis direction side of the bottom cover 42. However, the connector 64e may be fixed in an unmovable manner to the bottom portion 23a of the bottom cover 42. In such a case, in a state where the tip of the connector 64e is inserted into the connector insertion hole 42b of the bottom portion 23a from the -Z-axis direction side, the connector 64e is fixed in an unmovable manner to the bottom portion 23a. The tip of the connector 64e is constantly exposed in the +Z-axis direction side of the bottom cover 42.

## Claims

1. A holding apparatus (10) that holds an electric device (12) including a first electric terminal (50), the holding apparatus comprising:
a holding portion (14) configured to hold the electric device;
a second electric terminal (64e) configured to be connected to the first electric terminal of the electric device held by the holding portion; and
a drive portion (64f, 64f1, 64d3) configured to move the second electric terminal in a direction toward the first electric terminal and/or move the second electric terminal in a direction away from the first electric terminal,
wherein:
the holding portion is formed with a shape of a bottomed tube including a bottom portion (23a) and a tubular portion (23b) ;
the holding portion includes: a first member (42) that includes the bottom portion; and a second member (22) that is attached to the first member and that includes the tubular portion which surrounds an outer periphery of the electric device held in the holding portion; and
the second electric terminal and the drive portion are attached to the first member and are supported by the first member.

2. The holding apparatus according to claim 1, wherein:
the second electric terminal and the drive portion are arranged so as to be within a range of a projection of an outer edge of the first member.

3. The holding apparatus according to claim 2, wherein:
the drive portion includes:
an electric machine (64f) configured to receive a supply of electric power and generate drive force; and
a drive force transmission mechanism (64f1, 64d3) configured to mechanically connect the electric machine and the second electric terminal, and
the electric machine and the drive force transmission mechanism are arranged so as to be within the range of the projection of the outer edge of the first member.

4. The holding apparatus according to any one of claims 1 to 3, wherein:
the first member includes an extending portion (64a) that is provided extending from a surface of the bottom portion that is opposite to a surface thereof that faces toward the second member; and
the second electric terminal and the drive portion are attached to the extending portion.

5. The holding apparatus according to claim 4, wherein:
the extending portion is arranged so as to be within a range of a projection of an outer edge of the first member.

6. The holding apparatus according to any one of claims 1 to 4, further comprising:
an abutment portion (64d4) configured to move integrally with the second electric terminal; and
a connection detecting portion (64b) configured to detect that the first electric terminal and the second electric terminal are connected, based on abutting against the abutment portion when the first electric terminal and the second electric terminal are connected.

7. The holding apparatus according to claim 6, wherein:
the connection detecting portion is arranged so as to be within a range of a projection of an outer edge of the first member.

8. The holding apparatus according to any one of claims 1 to 7, further comprising:
an abutment portion (64d4) configured to move integrally with the second electric terminal; and
a disconnection detecting portion (64c) configured to detect that the first electric terminal and the second electric terminal are disconnected, based on abutting against the abutment portion when the first electric terminal and the second electric terminal are disconnected.

9. The holding apparatus according to claim 8, wherein:
the disconnection detecting portion is arranged so as to be within a range of a projection of an outer edge of the first member.

10. The holding apparatus according to any one of claims 1 to 9, wherein:
the holding portion includes a holding detection portion (32) disposed on a surface (42), of the holding portion, that faces toward a bottom surface (12b) of the electric device, the holding detection portion being configured to detect that the electric device is held inside the holding portion, based on abutting against the bottom surface;
the electric device includes a recessed portion (12g) formed to be recessed in the bottom surface;
the holding detection portion is arranged at a position that causes the holding detection portion to abut against the bottom surface when the electric device is held inside the holding portion while facing in a first direction, and also that causes the holding detection portion to be inserted into the recessed portion when the electric device is held inside the holding portion while facing in a second direction that is different from the first direction; and
the holding detection portion does not abut against the bottom surface when the electric device is held inside the holding portion while facing in the second direction.

11. The holding apparatus according to claim 10, wherein:
the holding detection portion is arranged so as to be within a range of a projection of an outer edge of the first member.

12. The holding apparatus according to any one of claims 1 to 11, wherein:
the first member includes, in the bottom portion, a communication path (42a, 42b, 42c, 42d) configured to allow an inside and an outside of the holding portion to communicate with each other.

13. The holding apparatus according to claim 12, further comprising:
a blowing portion (62) configured to facilitate a flow of air between the inside and the outside of the holding portion, wherein:
the blowing portion is attached to a position corresponding to the communication path on a surface of the bottom portion that is opposite to a surface thereof that faces toward the second member, and the blowing portion is supported by the first member.

14. The holding apparatus according to claim 13, wherein:
the blowing portion is arranged so as to be within a range of a projection of an outer edge of the first member.

15. The holding apparatus according to any one of claims 1 to 14, further comprising:
an electronic circuit (66) that is electrically connected to an electronic device (32, 62, 64b, 64c, 64f) installed in the holding portion, wherein:
the electronic circuit is attached to the first member and supported by the first member.

16. The holding apparatus according to claim 15, wherein:
the electronic circuit is arranged so as to be within a range of a projection of an outer edge of the first member.
